# EUROPEAN PATENT APPLICATION

(11) **EP 4 610 669 A1**
(43) Date of publication of application: **03.09.2025**
(21) Application number: 23882191.2
(22) Date of filing: 08.08.2023
(51) Int. Cl.: G01R 15/20, G01R 33/02

(54) **ELECTRIC CURRENT SENSOR**

(30) Priority: 24.10.2022 JP 2022170080
(71) Applicant: Alps Alpine Co., Ltd., Tokyo 145-8501 (JP)
(72) Inventor: TAMURA, Manabu, Tokyo 145-8501 (JP)
(74) Representative: Maiwald GmbH
(86) International application number: PCT/JP2023/028932
(87) International publication number: WO 2024/089975

(57) **Abstract**

A current sensor 1 according to the present invention includes a busbar 11 through which a current to be measured flows, a magnetic detection unit 12 capable of detecting a magnetic field generated when the current to be measured flows through the busbar 11, a casing 13 that holds the busbar 11, a first magnetic shield 14A capable of reducing disturbance magnetic field noise applied to the magnetic detection unit 12, a substrate 15 having the magnetic detection unit 12 on an X1 side surface of the substrate 15 in the X-axis direction, where the busbar 11, the magnetic detection unit 12, the substrate 15, and the first magnetic shield 14A are disposed in this order from the X1 side, and a spacer portion 16 between the casing 13 and the substrate 15 to separate the busbar 11 from the magnetic detection unit 12 in the X-axis direction. The substrate 15 has a protruding portion 151 protruding from the position where it is held by the spacer portion 16 in at least one of protruding directions that are the Y-axis direction and the Z-axis direction and, thus, an electronic component, such as the magnetic detection unit, is prevented from having a high temperature caused by heat generated by the busbar. The current sensor 1 is suitable for measuring a large amount of current.

## Description

### Technical Field

The present invention relates to a current sensor that detects a magnetic field generated by a current to be measured flowing through a busbar and measures the current value of the measured current from the detected magnetic field.

### Background Art

In recent years, with the growing demand for decarbonization, there has been a shift from internal combustion engines to electric motors, that is, a shift from gasoline-powered cars to electric vehicles (EV shift) in order to curb emissions of CO₂ during vehicle operation, and current sensors are used as current measurement devices to measure the current or the like supplied to three-phase motors. As the EV shift spreads to big commercial vehicles, such as trucks and buses, the motor capacities of hybrid vehicles and electric vehicles are also increasing, and the currents measured by current sensors to control the motors are also increasing. In addition, the opportunities for continuous driving under high load conditions are also increasing and, thus, the continuously flowing current is increasing. A busbar, which is the current path of the current to be measured, generates the amount of heat proportional to the square of the magnitude of the current. For this reason, the amount of heat generated from the busbar increases with increasing amount of continuously flowing current to be measured. The increase in the amount of generated heat increases the temperature of electronic components, such as the magnetic detection units, disposed in the vicinity of the busbars, which is problematic. PTL 1 describes a current sensor having a heat radiating uneven portion in the insulating material part of the casing to prevent a decrease in detection accuracy of the current sensor caused by high temperature. PTL 2 describes a current sensor in which a magnetic detection unit is provided inside of a cover having a shield that is insert-molded, for the purpose of reducing the size.

### Citation List

### Patent Literature

PTL 1: International Publication No. WO2019/092912
PTL 2: International Publication No. WO2019/117169

### Summary of Invention

### Technical Problem

According to the current sensor described in PTL 1, the size of the product and the manufacturing cost increase due to the heat radiating uneven portion provided in a cover. According to the current sensor including a magnetic detection unit in a cover and described in PTL 2, the temperature in a storage space may increase beyond the heat-resistant temperature of the magnetic detection unit due to the heat generated by a busbar, thus decreasing the measurement accuracy of the current sensor and decreasing the product life. Accordingly, it is an object of the present invention to provide a current sensor including electronic components, such as a magnetic detection unit, that are unlikely to have a high temperature due to the heat generated by the busbar and, thus, being suitable for measuring large currents. It is another object of the present invention to provide a current sensor that can be miniaturized without reducing measurement accuracy.

### Solution to Problem

As means for solving the above-described problems, the present invention provides the following configuration. A current sensor includes a busbar through which a current to be measured flows, a magnetic detection unit configured to detect a magnetic field generated when the current to be measured flows through the busbar, a casing configured to hold the busbar, a first magnetic shield configured to reduce disturbance magnetic field noise applied to the magnetic detection unit, a substrate having the magnetic detection unit on a surface of the substrate on one side in a first direction where three directions perpendicular to one another are defined as the first direction, a second direction, and a third direction, and where the busbar, the magnetic detection unit, the substrate, and the first magnetic shield are disposed in this order from the one side in the first direction, and a spacer portion provided between the casing and the substrate to separate the busbar from the magnetic detection unit in the first direction. The substrate has a protruding portion protruding from a position where the substrate is held by the spacer portion in at least one of protruding directions that are the second direction and the third direction.

The substrate can dissipate the heat generated from the busbar due to the current to be measured from its protruding portion to the outside. This reduces the temperature rise of the magnetic detection unit located on the substrate due to the heat generated by the busbar.

The spacer portion may be integrally provided with the casing. Forming the spacer portion integrally with the casing increases the strength of the spacer portion. In addition, since the spacer portion can be formed at the same time as the casing, the spacer portion can be manufactured efficiently.

The casing may have a body on the one side of the spacer portion in the first direction, and the body may have an extending portion that extends from a point where the spacer portion is provided in a direction including the protruding direction. As viewed along the first direction, the extending portion may have a facing portion that overlaps the protruding portion and a protective portion located outside the edge of the protruding portion. The casing may have a guard portion extending from the protective portion toward the other side in the first direction, and the guard portion may be separated from the protruding portion as viewed along the first direction. The above-described configuration can protect the protruding portion by the extending portion and the guard portion and, thus, can reduce the risk of the protruding portion coming into contact with an external obstacle and the risk of the substrate getting damaged when handling the current sensor.

The distance from the protective portion to the edge of the guard portion in the first direction may be greater than or equal to the distance from the protective portion to the mounting surface of the substrate on which the first magnetic shield is mounted and less than or equal to the distance from the protective portion to the upper surface of the first magnetic shield in the first direction. The above-described configuration can protect the protruding portion by the guard portion without increasing the dimensions of the current sensor in the first direction.

As viewed along at least one of the second direction and the third direction, at least part of the guard portion may overlap the protruding portion. The above-described configuration enables the guard portion to cover the corners of the protruding portion and can prevent the protruding portion from contacting the outside.

The guard portion may be a plurality of plate members, and a gap may be formed between every adjacent pair of the plate members. The above-described configuration enables the gap between the guard portions to adjust the air flow generated in the space enclosed by the guard portion, the protruding portion, the spacer portion, and the facing portion. Therefore, the shape of the guard portion makes it possible to balance the protection of the protruding portion and the cooling effect of the substrate.

The first magnetic shield may be held by the substrate, and a side surface of the first magnetic shield may be covered by a covering portion. When the first magnetic shield is held by the substrate, the bottom surface (the upper surface) of the first magnetic shield remote from the substrate and the side surface of the first magnetic shield are exposed to the outside. In general, the bottom surface is covered with an insulating film formed thereon, whereas the side surface is a fracture surface. Therefore, by providing a covering portion that covers the side surface, it is possible to prevent generation of rust on the fracture surface of the first magnetic shield.

The current sensor may include a plurality of the measurement phases each having the busbar and the magnetic detection unit, and the first magnetic shield may be provided independently for each of the measurement phases. According to the above-described configuration, the first magnetic shield is less likely to be magnetically saturated than in the case where a large first magnetic shield is shared by a plurality of measurement phases. As a result, the first magnetic shield is more effective in reducing disturbance magnetic field noise, and the measurement accuracy of the current sensor is improved.

The spacer portion may have a communicating portion that is open in the second direction and/or the third direction. The above-described configuration can efficiently cool the space between the substrate and the busbars located on an inner side of the spacer portion.

The spacer portion may surround the magnetic detection unit as viewed along the first direction. The above-described configuration can protect the magnetic detection unit against the outside by the spacer portion.

The current sensor may further include a second magnetic shield, and the second magnetic shield, the busbar, the magnetic detection unit, the substrate, and the first magnetic shield may be disposed in this order from the one side in the first direction. The above-described configuration improves the effectiveness of reduction in noise caused by a disturbance magnetic field and, thus, improves the measurement accuracy of the current sensor.

The distance between the first magnetic shield and the busbar in the first direction may be greater than the distance between the second magnetic shield and the busbar in the first direction, and the thickness of the first magnetic shield may be less than the thickness of the second magnetic shield. By adjusting the thickness of each of the shields in accordance with the distance to the busbar, the thickness of the magnetic shield in the first direction can be reduced. This configuration can reduce the thickness of the magnetic shield and, thus, reduce the size of the current sensor.

### Advantageous Effects of Invention

According to the present invention, the heat generated by a busbar can be dissipated from a protruding portion of a substrate to the outside, thus reducing the temperature rise of the substrate and the magnetic detection unit. Therefore, a current sensor suitable for measuring large currents can be provided in which the temperature rise of electronic components, such as a magnetic detection unit, due to the heat generated by the busbars is reduced.

### Brief Description of Drawings

[Fig. 1] Fig. 1 is a perspective view of a current sensor according to a first embodiment.
[Fig. 2A] Fig. 2A is a cross-sectional view of the current sensor taken along a line A-A illustrated in Fig. 1.
[Fig. 2B] Fig. 2B is a plan view of the current sensor illustrated in Fig. 1.
[Fig. 3] Fig. 3 is a cross-sectional view of a modification of the current sensor illustrated in Fig. **2****.**
[Fig. 4] Fig. 4 is a cross-sectional view of a current sensor according to a second embodiment.
[Fig. 5] Fig. 5 is a plan view of the current sensor illustrated in Fig. 4.
[Fig. 6] Fig. 6 is a plan view of a modification of the current sensor illustrated in Fig. 4.
[Fig. 7] Fig. 7 is a plan view of another modification of the current sensor illustrated in Fig. 4.
[Fig. 8] Fig. 8 is a cross-sectional view of a current sensor according to a third embodiment.
[Fig. 9] Fig. 9 is a cross-sectional view of a modification of the current sensor illustrated in Fig. 8.
[Fig. 10] Fig. 10 is a cross-sectional view of another modification of the current sensor illustrated in Fig. 8.
[Fig. 11] Fig. 11 is a perspective view of a current sensor according to a fourth embodiment.
[Fig. 12] Fig. 12 is a cross-sectional view of the current sensor taken along a line A-A of Fig. 11.
[Fig. 13] Fig. 13 is a cross-sectional view of a modification of the current sensor illustrated in Fig. 12.
[Fig. 14] Fig. 14 is a cross-sectional view of a current sensor according to a fifth embodiment.
[Fig. 15] Fig. 15 is a cross-sectional view of an existing current sensor.
[Fig. 16] Fig. 16 is a cross-sectional view of an existing current sensor.

### Description of Embodiments

Embodiments of the present invention are described below with reference to the accompanying drawings. The same reference numerals are used throughout the drawings to describe those members that are identical, and their description is not repeated. To describe the positional relationship among the members, the reference coordinates are illustrated in each of the drawings as appropriate. The directions of the reference coordinates are the X-axis direction (a first direction) that is the normal direction of the plate surface of a busbar, the Y-axis direction (a second direction) that is perpendicular to the extension direction of the busbar on the plate surface of the busbar, and the Z-axis direction (a third direction) that is the extension direction of the busbar.

### [First Embodiment]

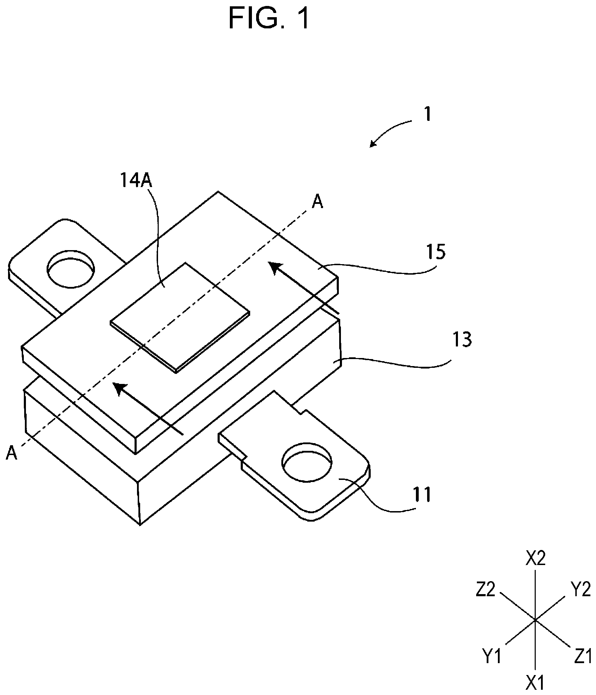

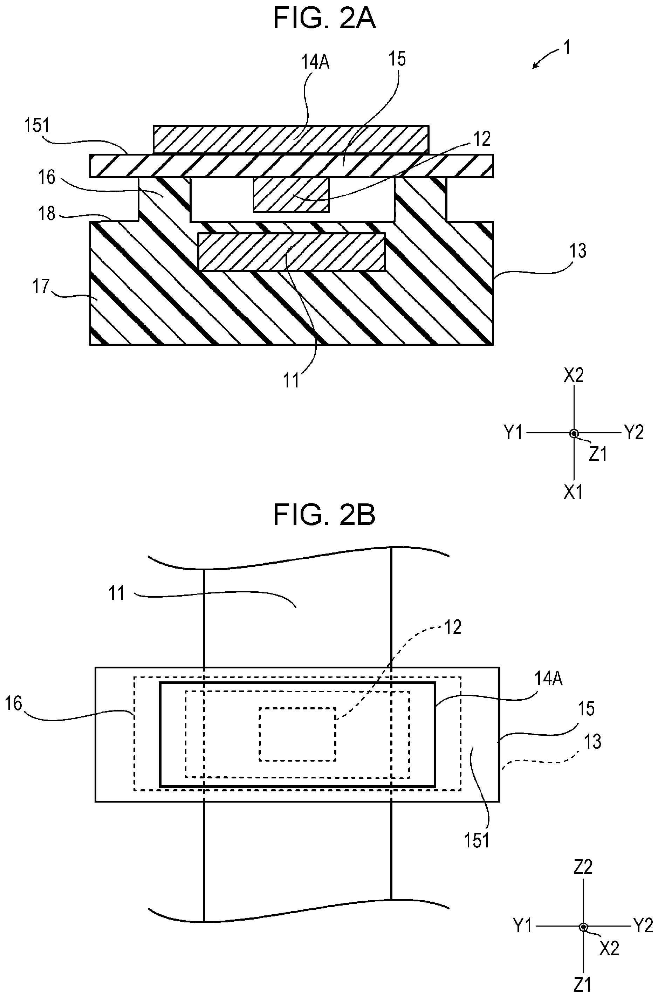

Fig. 1, Fig. 2A, and Fig. 2B are a perspective view, a cross-sectional view, and a plan view of a current sensor 1 according to the present embodiment, respectively. Fig. 2A is a cross-sectional view taken along a line A-A illustrated in Fig. 1. As illustrated in the drawings, the current sensor 1 according to the present embodiment includes a busbar 11, a magnetic detection unit 12, a casing 13, a first magnetic shield 14A, and a substrate 15. The members (the busbar 11, the magnetic detection unit 12, the substrate 15, and the first magnetic shield 14A) are disposed in this order from the X1 side (one side) to the X2 side (the other side) in the X-axis direction (the first direction).

The busbar 11 is a conductive member formed in the shape of a plate, through which a measured current to be detected flows. The busbar 11 is provided such that two facing plate surfaces correspond to the top and bottom of the casing 13 (both sides in the X-axis direction). The busbar 11 is made of copper, brass, aluminum, or the like, for example.

Both edge portions of the busbar 11 in the Z-axis direction, which are the connecting portions with the outside, do not necessarily have to be line symmetrical with respect to the Z-axis. A portion of the busbar 11 facing the magnetic detection unit 12 may have a smaller dimension in the Y-axis direction than the other portion of the busbar 11. The portion of the busbar 11 other than the portion facing the magnetic detection unit 12 does not necessarily have a flat plate shape and may be bent, for example.

The magnetic detection unit 12 can detect the magnetic field generated when a current to be measured flows through the busbar 11. The magnetic detection unit 12 is disposed at a position away from the busbar 11 and facing the busbar 11 so that the direction of the sensitive axis is perpendicular to the direction of the current to be measured flowing through the busbar. In Figs. 2A and 2B, the magnetic detection unit 12 is disposed such that the center of the width of the magnetic detection unit 12 in the Y-axis direction overlaps the center of the width of the busbar 11 in the Y-axis direction as viewed along the X-axis. However, the magnetic detection unit 12 only needs to be disposed at a position where it can measure the magnetic field generated when the current to be measured flows through the busbar 11. Therefore, the entire magnetic detection unit 12 may be disposed at a position displaced from the position where the magnetic detection unit 12 overlaps the busbar 11. At this time, it is desirable that part of the magnetic detection unit 12 overlap the facing busbar 11 as viewed along the X-axis. A magnetoresistive element, a Hall element, or the like may be used as a magnetic detection element of the magnetic detection unit 12.

The casing 13 holds the busbar 11. In the current sensor 1, part of the busbar 11 is integrally formed with the casing 13 by insert molding.

The first magnetic shield 14A is formed by, for example, stacking a plurality of metal plate members of the same shape on top of each other. Since the first magnetic shield 14A can block the disturbance magnetic field noise and reduce the disturbance magnetic field noise applied to the magnetic detection unit 12, the disturbance magnetic field noise immunity of the magnetic detection unit 12 is improved.

In the current sensor 1, the first magnetic shield 14A is provided on the X2 side (the other side) of the substrate 15 in the X-axis direction. The first magnetic shield 14A provided on the X2 side can reduce disturbance magnetic field noise, but a magnetic shield may also be provided on the X1 side of the busbar 11. By employing the configuration in which the magnetic detection unit 12 and the busbar 11 are disposed between a pair of flat-plate shaped magnetic shields, the disturbance magnetic field immunity of the magnetic detection unit 12 is further improved.

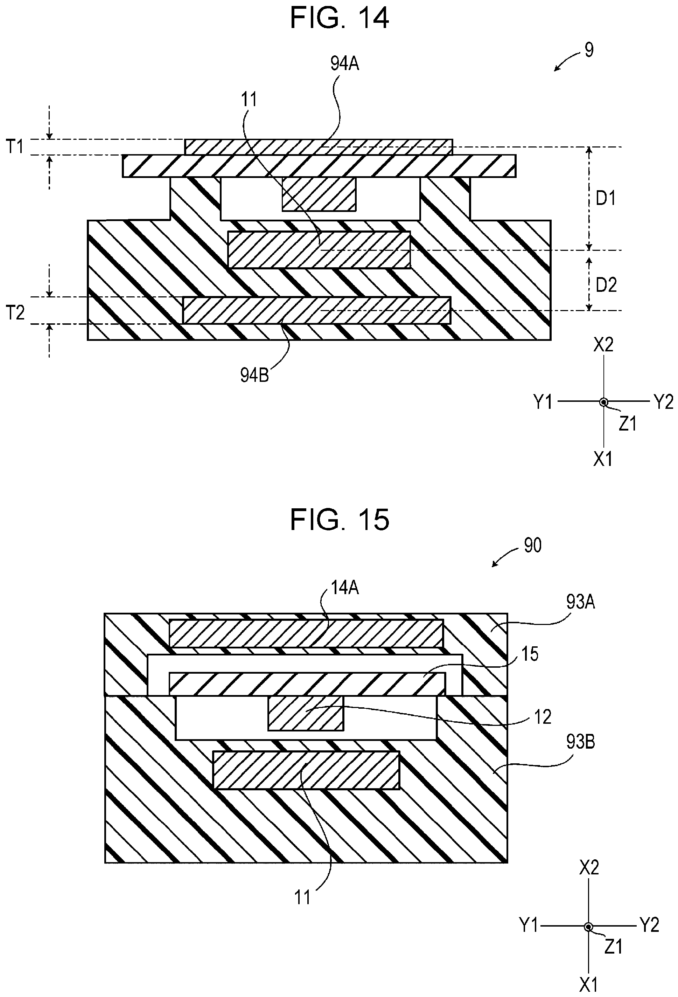

Fig. 15 is a cross-sectional view of the configuration of an existing current sensor 90. As illustrated in Fig. 15, in the current sensor 90, the first magnetic shield 14A is integrally molded into a casing 93A, and the first magnetic shield 14A is separated from the substrate 15.

In contrast, as illustrated in Fig. 2, in the current sensor 1, the first magnetic shield 14A is held on a X2 side surface of the substrate 15. Therefore, the distance between the first magnetic shield 14A and the substrate is less than that in the current sensor 90 in which the first magnetic shield 14A is separated from the substrate 15, reducing the dimension in the height direction (the X-axis direction). In addition, since the position of the first magnetic shield 14A is close to the magnetic detection unit 12, the external magnetic field shielding effect of the first magnetic shield 14A is improved, making the current sensor 1 less susceptible to an external magnetic field. As a result, the measurement accuracy of the current sensor 1 is improved.

In the existing current sensor 90, the substrate 15 having the magnetic detection unit 12 mounted thereon is disposed in the space between the casing 93A and a casing 93B. Therefore, when a large current is applied to the busbar 11, the air in the space may be heated by the heat generated by the busbar 11 to a temperature exceeding the usable upper limit temperature of the magnetic detection unit 12.

In contrast, according to the current sensor 1, at least part of the substrate 15 is exposed to the outside of the casing 13 made of resin, so that heat is easily dissipated to the outside through the substrate 15. Therefore, the temperature rise caused by the heat generated by the busbar 11 can be prevented in the space where the magnetic detection unit 12 is provided.

According to the current sensor 1, the other side (X2 side) surface of the first magnetic shield 14A held by the substrate 15 (the surface opposite the bottom surface facing the substrate 15) is exposed to the outside. Therefore, although part of the substrate 15 is covered by the first magnetic shield 14A, the substrate 15 can dissipate heat to the outside via the first magnetic shield 14A. As a result, the temperature rise around the magnetic detection unit 12 due to the heat generated by the busbar 11 can be reduced. The substrate 15 can be made of, for example, epoxy glass or ceramic.

The first magnetic shield 14A is formed on the substrate 15 by, for example, bonding and fixing the first magnetic shield 14A to the substrate 15, stacking the substrate 15 and the first magnetic shield 14A and applying heat and pressure to them in a vacuum (lamination press), printing magnetic shield paste or the like on the substrate 15 to form the first magnetic shield 14A, forming the first magnetic shield 14A by plating and fixing it to the substrate 15 by soldering, or swaging pins in the first magnetic shield 14A and soldering the pins to the substrate 15.

The current sensor 1 has a spacer portion 16 between the casing 13 and the substrate 15. The spacer portion 16 separates the busbar 11 from the magnetic detection unit 12 in the X-axis direction and separates the substrate 15 from the casing 13. In the current sensor 1, the spacer portion 16 is integrally provided with the casing 13, so that the spacer portion 16 with excellent strength can be manufactured efficiently. Although the manufacturing efficiency is improved by providing at least part of the spacer portion 16 integrally with the casing 13, the spacer portion 16 may be formed using a member other than the casing 13.

As illustrated in Figs. 2A and 2B, in the current sensor 1, the magnetic detection unit 12 is surrounded by the spacer portion 16 as viewed along the X-axis direction. This configuration can protect the magnetic detection unit 12 by the spacer portion 16.

The substrate 15 has a protruding portion 151 that protrudes from the position where the substrate 15 is held by the spacer portion 16 in at least one of protruding directions that are the Y-axis direction and the Z-axis direction. According to the present embodiment, the Y-axis direction (the second direction) and the Z-axis direction (the third direction) are two directions each perpendicular to the X-axis direction (the first direction) and perpendicular to each other.

As illustrated in Fig. 2A, if the protruding portion 151 is located in the Y-axis direction inside of the cross section of the current sensor 1 in the XY plane, the protruding direction includes the Y-axis direction. If the protruding portion is located inside of the cross section of the current sensor 1 in the XZ plane (not illustrated), the protruding direction includes the Z-axis direction. The protruding direction of the protruding portion 151 may be one of the Y-axis and Z-axis directions or both the Y-axis and Z-axis directions. According to the present embodiment, the protruding portion 151 is provided to protrude in both the Y-axis and Z-axis directions, and the substrate 15 is rectangular in shape as viewed along the X-axis direction.

Since both side surfaces of the protruding portion 151 in the X-axis direction, that is, two surfaces each having the perpendicular line that is parallel to the X-axis, are exposed without contacting the casing 13 and the spacer portion 16, the heat of the substrate 15 can be efficiently dissipated from the protruding portion 151 to the outside. The heat dissipation from the protruding portion 151 reduces the temperature rise around the magnetic detection unit 12 disposed on the substrate 15 due to the heat transferred from the busbar 11. As a result, deterioration of the measurement accuracy of the current sensor 1 caused by the heat generated by the busbar 11 can be reduced.

The casing 13 includes a body 17 on the X1 side of the spacer portion 16 in the X-axis direction. The body 17 has an extending portion 18 that extends from the position where the spacer portion 16 is provided in a direction including the protruding direction. By providing the extending portion 18 in the body 17, the extending portion 18 protects the protruding portion 151 and reduces the risk of the protruding portion 151 colliding with external obstacles and the risk of the substrate 15 or a member provided on the substrate 15 getting damaged when the current sensor 1 is handled.

### <Modification>

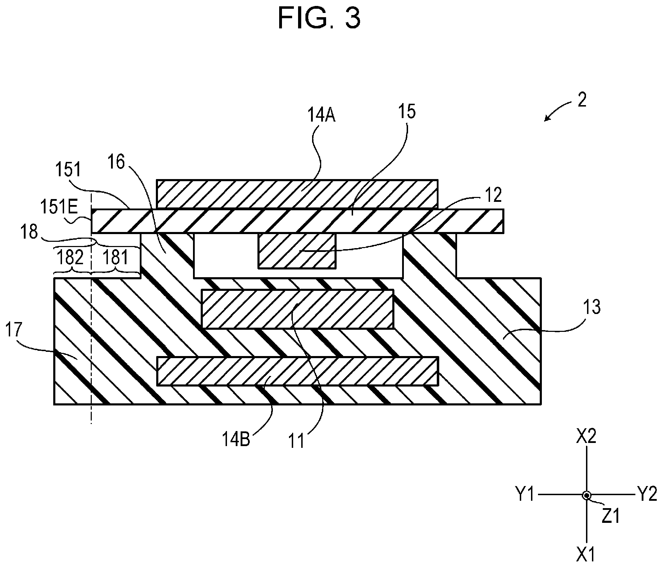

Fig. 3 is a cross-sectional view of a current sensor 2 that is a modification of the current sensor 1. As illustrated in Fig. 3, unlike the current sensor 1, the current sensor 2 has a configuration in which the extending portion 18 consists of a facing portion 181 and a protective portion 182.

The facing portion 181 is a portion disposed facing the protruding portion 151, that is, a portion of the extending portion 18 that overlaps the protruding portion 151 as viewed along the X-axis direction. The protective portion 182 is a portion that is located on the outer side of an edge 151E of the protruding portion 151 and does not overlap the protruding portion 151 as viewed along the X-axis direction. The extending portion 18 having the protective portion 182 in addition to the facing portion 181 facilitates contact of the extending portion 18 with the outside before the protruding portion 151 comes into contact with the outside. Therefore, the risk of the protruding portion 151 coming into contact with the outside can be reduced and, thus, the risk of the substrate 15 or the like getting damaged can be reduced.

Unlike the current sensor 1, the current sensor 2 has a configuration including a second magnetic shield 14B in addition to the first magnetic shield 14A. The members, that is, the second magnetic shield 14B, the busbar 11, the magnetic detection unit 12, the substrate 15, and the first magnetic shield 14A are disposed in this order from the X1 side to the X2 side in the X-axis direction.

The second magnetic shield 14B disposed in the vicinity of the busbar 11 is integrally formed with the body 17 of the casing 13 together with the busbar 11. The busbar 11 and the magnetic detection unit 12 are provided between the first magnetic shield 14A and the second magnetic shield 14B so as to effectively reduce noise caused by a disturbance magnetic field. As a result, the current sensor 2 with excellent measurement accuracy can be provided.

### [Second Embodiment]

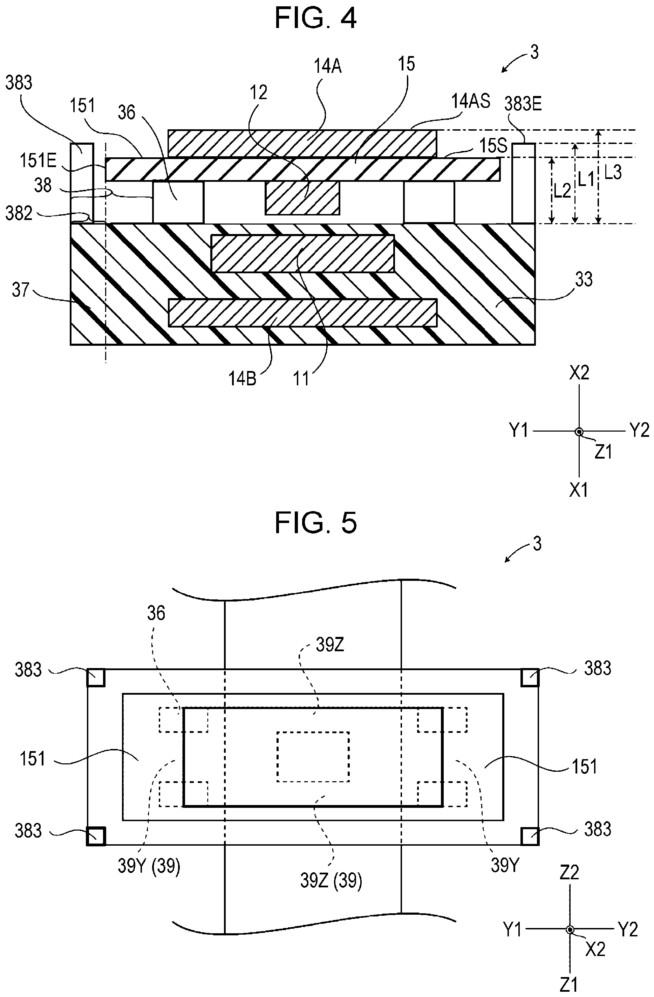

Figs. 4 and 5 are a cross-sectional view and a plan view of a current sensor 3 according to the present embodiment, respectively. As illustrated in Figs. 4 and 5, unlike the current sensor 1 and the current sensor 2, the current sensor 3 has a configuration in which a body 37 of a casing 33 has a guard portion 383 extending from a protective portion 382 of an extension portion 38 toward the X2 side in the X-axis direction.

As illustrated in Fig. 4, a distance L1 from the protective portion 382 to an edge 383E of the guard portion 383 in the X-axis direction is greater than or equal to a distance L2 from the protective portion 382 to a mounting surface 15S of the substrate 15 on which the first magnetic shield 14A is mounted and less than or equal to a distance L3 from the protective portion 382 to an upper surface 14AS of the first magnetic shield 14A (L2 ≤ L1 ≤ L3). Therefore, the edge 383E of the guard portion 383 is located between the upper surface 14AS of the first magnetic shield 14A and the mounting surface 15S of the first magnetic shield 14A of the substrate 15.

As illustrated in Fig. 5, the guard portion 383 is separated from the protruding portion 151 as viewed along the X-axis direction, so that the guard portion 383 is likely to come into contact with the outside earlier than the protruding portion 151. Therefore, the guard portion 383 can protect the protruding portion 151 and reduce the risk of the protruding portion 151 colliding with an external obstacle and the risk of the substrate 15 or the like getting damaged.

In addition, unlike the current sensor 1 and the current sensor 2, a spacer portion 36 of the current sensor 3 has a communicating portion 39 that is open in a direction that intersects with the X-axis direction. In the current sensor 3, the spacer portion 36 consists of four columnar members, and the gaps between every adjacent pair of columnar members correspond to communicating portions 39Y that are open in the Y-axis direction and communicating portions 39Z that are open in the Z-axis direction. The spacer portion 36 may be configured to have, for example, more than four columnar members or may be configured to have the communicating portion 39 only in either the Y-axis direction or the Z-axis direction. The spacer portion 36 may be formed by a plate member having a hole that functions as the communicating portion 39. By providing the communicating portion 39, heat can be dissipated to the outside via the communicating portion 39, thus preventing a high temperature around the magnetic detection unit 12.

### <Modification>

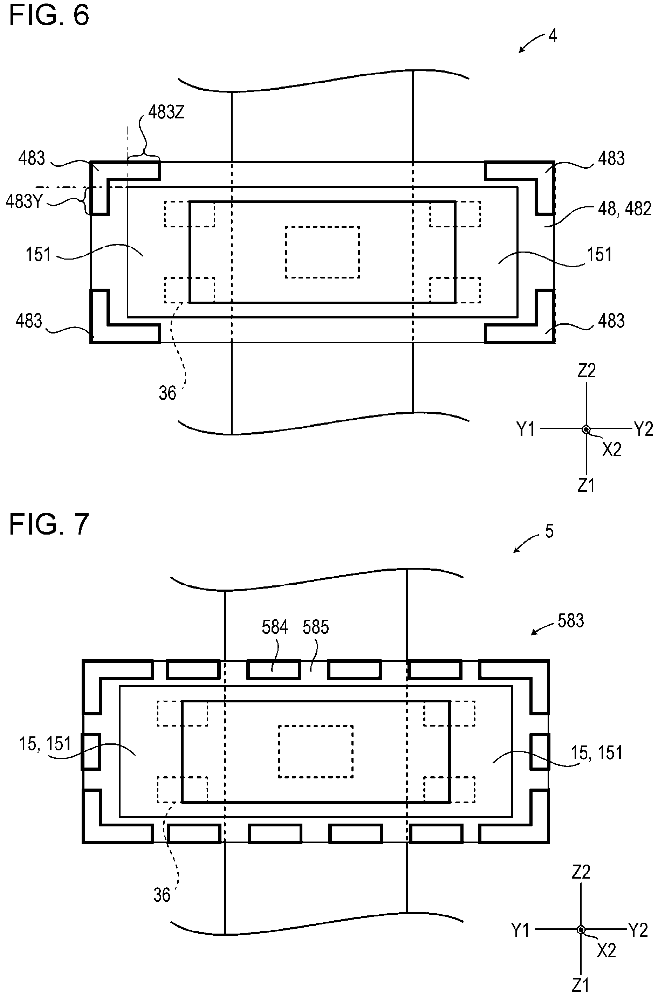

Fig. 6 is a plan view of a current sensor 4 that is a modification of the current sensor 3 illustrated in Figs. 4 and 5. In the current sensor 4 illustrated in Fig. 6, at least part of a guard portion 483 overlaps the protruding portion 151 as viewed along at least one of the Y-axis direction and Z-axis direction. That is, the guard portion 483 has a guard portion 483Y that overlaps the protruding portion 151 as viewed along the Y-axis direction and a guard portion 483Z that overlaps the protruding portion 151 as viewed along the Z-axis direction. The configuration enables the guard portions 483 provided at the four corners of a protective portion 482 of the extension portion 48 to surround the corners of the protruding portion 151, respectively. Thus, during handling, the risk of the protruding portion 151 coming into contact with the outside and the risk of the substrate 15 or the like getting damaged can be reduced.

In Fig. 6, all of the guard portions 483 provided at the four corners are configured to each have guard portions 483Y and 483Z, but some or all of the guard portions 483 can be configured to each have one of the guard portions 483Y and 483Z.

Fig. 7 is a plan view of a current sensor 5 that is another modification of current sensor 3 illustrated in Fig. 4. A guard portion 583 of the current sensor 5 illustrated in Fig. 7 consists of a plurality of plate members 584, and a gap 585 is provided between every adjacent pair of the plate members 584. The configuration makes it possible to balance the protection of the protruding portion 151 and the cooling effect of the substrate 15 by adjusting the ratio between the plate members 584 and the gaps 585 that form the guard portion 583.

In Fig. 7, the gap 585 is provided between the guard portion 583 and the plate member 584, but the gap 585 can be eliminated. This can apply to the configuration illustrated in Fig. 6. Even when the gap 585 is not provided, an air passage is secured, since the substrate 15 and the spacer portion 36 are separated from the guard portion 583 and, thus, the heat can be sufficiently dissipated.

### [Third Embodiment]

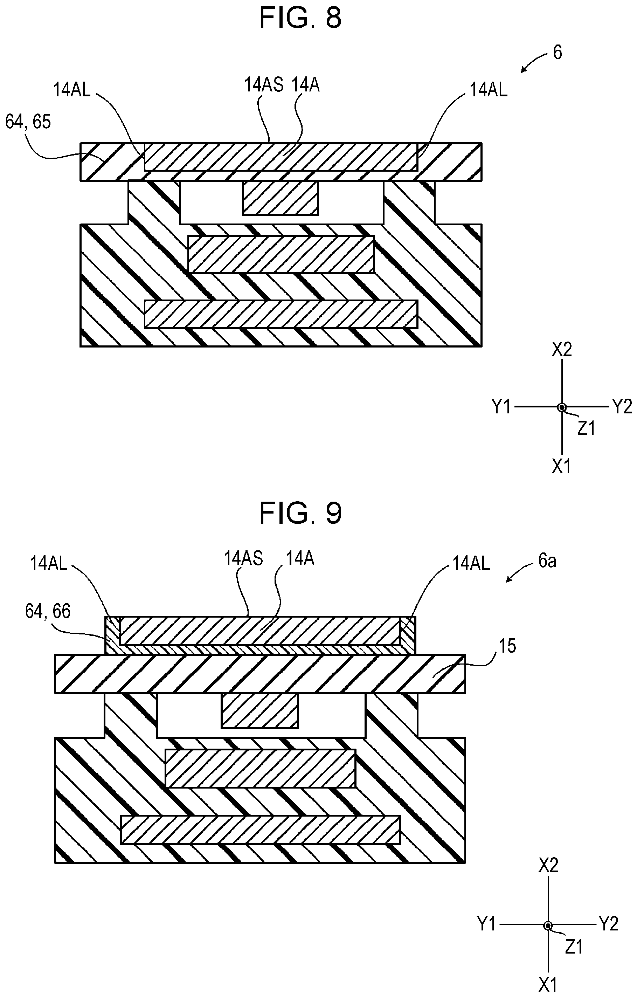

Fig. 8 is a cross-sectional view of a current sensor 6 according to the present embodiment. As illustrated in Fig. 8, unlike the current sensor 1 illustrated in Fig. 2A, the current sensor 6 has a configuration in which a side surface 14AL of the first magnetic shield 14A held by a substrate 65 is covered by the substrate 65.

The first magnetic shield 14A is formed by die cutting the outer shape from a plate material with both surfaces subjected to surface treatment (for example, plating) by using a press metal die or the like. Therefore, the plate surfaces of the first magnetic shield 14A (the upper surface 14AS and the lower surface) are subjected to surface treatment. However, the side surface 14AL, which is a fracture surface formed by die cutting, is not subjected to surface treatment. For this reason, if the side surface 14AL is left exposed without secondary processing, such as plating, rust may occur on the side surface 14AL, and the rust may fall upon a wiring portion or the like provided around the side surface 14AL. As a result, a short circuit or other problems may arise.

Therefore, the current sensor 6 according to the present embodiment includes a covering portion 64 that covers the side surface 14AL of the first magnetic shield 14. In the current sensor 6 illustrated in Fig. 8, the side surface 14AL of the first magnetic shield 14A is covered by the substrate 65, and the substrate 65 functions as the covering portion 64. The configuration reduces rust that occurs on the side surface 14AL of the first magnetic shield 14A, even if the side surface 14AL is a fracture surface.

In the current sensor 6, the first magnetic shield 14A is buried in the substrate 65 to cover the side surface 14AL. Therefore, the need for additionally providing a cover that covers the side surface 14AL is eliminated. Thus, the size of the current sensor 6 can be reduced. As described above, the upper surface 14AS of the first magnetic shield 14A, which is exposed from the substrate 65, is generally subjected to surface treatment. Therefore, by covering the side surface 14AL, which is a fracture surface, with the substrate 65 (by burying the side surface 14AL in the substrate 65), the fracture surface is prevented from being exposed.

### <Modifications>

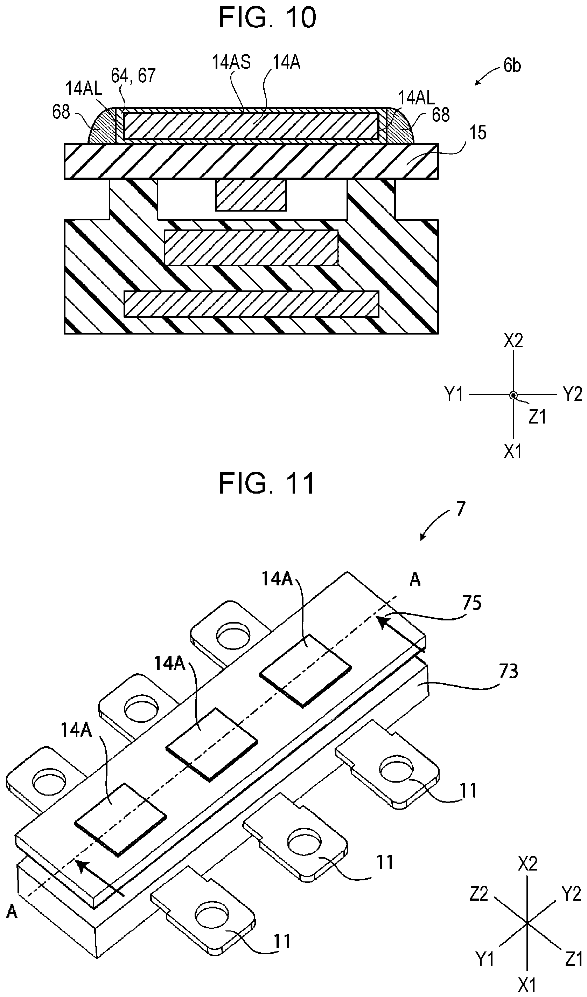

Figs. 9 and 10 are a cross-sectional view of a current sensor 6a, which is a modification of the current sensor 6 illustrated in Fig. 8, and a cross-sectional view of a current sensor 6b, which is another modification of the current sensor 6, respectively. In the current sensor 6a illustrated in Fig. 9, the side surface 14AL of the first magnetic shield 14A is covered by an adhesive agent 66 that bonds the first magnetic shield 14A to the substrate 15 and, thus, the adhesive agent 66 functions as the covering portion 64.

In the current sensor 6b illustrated in Fig. 10, the surface of the first magnetic shield 14A is subjected to plating 67, and the first magnetic shield 14A is attached to the substrate 15 by using a solder 68. The side surface 14AL of the first magnetic shield 14A is covered by the plating 67. Since the first magnetic shield 14A is covered by the plating 67 serving as the covering portion 64, the side surface 14AL does not rust. Therefore, the first magnetic shield 14A may be bonded to the substrate 15 using the adhesive agent 66 or the like instead of using the solder 68. When the solder 68 is used, the region of the first magnetic shield 14A soldered and fixed to the substrate 15 may be the whole circumference, only the side wall, or points (multiple points) of the first magnetic shield 14A.

The configuration illustrated in Figs. 8 to 10 enables the covering portion 64 to cover the side surface 14AL of the first magnetic shield 14A without mounting a cover over the side surface 14AL, thus preventing the fracture surface of the first magnetic shield 14A from being exposed to the outside. Therefore, the rusting of the first magnetic shield 14A can be prevented without increasing the sizes of the current sensors 6, 6a, and 6b.

### [Fourth Embodiment]

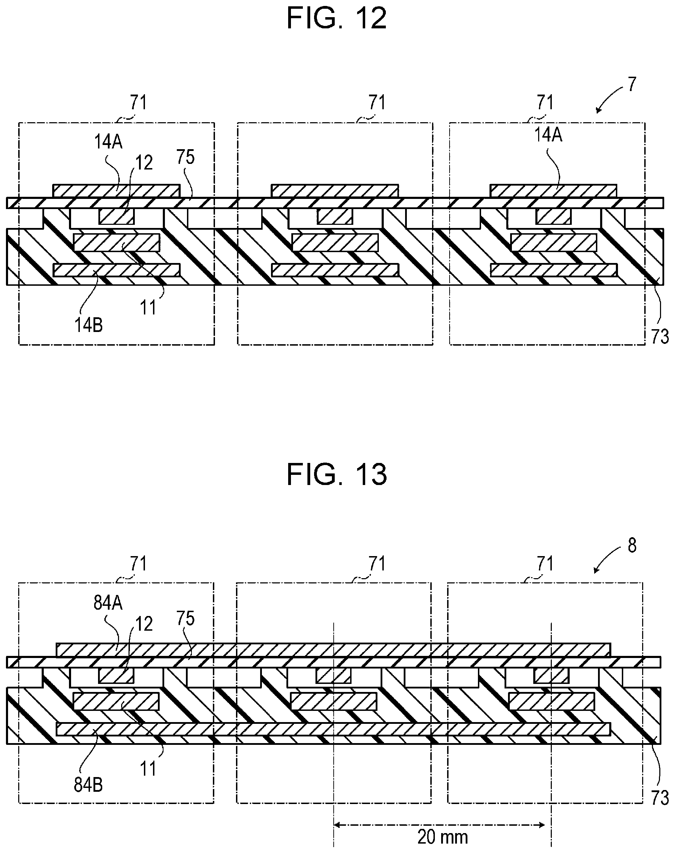

Figs. 11 and 12 are a perspective view and a cross-sectional view of a current sensor 7 according to the present embodiment, respectively. Fig. 12 is a cross-sectional view taken along a line A-A illustrated in Fig. 11. Unlike the current sensor 1 and the current sensor 2, the current sensor 7 has a configuration with three measurement phases 71 each having a busbar 11 and a magnetic detection unit 12. The three busbars 11 are provided in a casing 73, and the three magnetic detection units 12 are provided on a substrate 75. Although Figs. 11 and 12 illustrate the current sensor 7 with a configuration having three measurement phases 71 as an example, the present invention may be practiced as a current sensor with a configuration having two or four or more measurement phases 71.

Fig. 13 is a cross-sectional view of a current sensor 8 that is a modification of the current sensor 7. The current sensor 8 includes a pair consisting of a first magnetic shield 84A and a second magnetic shield 84B for the three measurement phases 71. That is, the first magnetic shield 84A and the second magnetic shield 84B are provided across the three measurement phases 71. In this way, the first magnetic shield 84A and the second magnetic shield 84B can be shared by a plurality of measurement phases 71.

However, according to a configuration with a plurality of measurement phases 71, if, like the current sensor 8, a pair consisting of the first magnetic shield 84A and the second magnetic shield 84B is provided for a plurality of the measurement phases 71, the first magnetic shield 84A and second magnetic shield 84B are easily magnetically saturated. In contrast, if, like the current sensor 7, the first magnetic shield 14A and the second magnetic shield 14B are provided independently for each of the measurement phases 71, the first magnetic shield 14A and the second magnetic shield 14B are less likely to be magnetically saturated. Therefore, when a plurality of measurement phases 71 are provided, it is desirable that, as in the case of the current sensor 7, the first magnetic shield 14A and the second magnetic shield 14B be provided independently for each of the measurement phases 71 to improve the measurement accuracy.

### [Fifth Embodiment]

Fig. 14 is a cross-sectional view of a current sensor 9 according to the present embodiment. As illustrated in Fig. 14, according to the current sensor 9, a distance D1 between a first magnetic shield 94A and the busbar 11 in the X-axis direction is greater than a distance D2 between a second magnetic shield 94B and the busbar 11 in the first direction (D1 > D2). In addition, a thickness T1 of the first magnetic shield 94A is less than a thickness T2 of the second magnetic shield 94B (T1 < T2). Thus, by adjusting the thickness T1 of the first magnetic shield 94A and the thickness T2 of the second magnetic shield 94B in accordance with the distances D1 and D2 from the busbar 11, the dimension of the current sensor 9 in the X-axis direction can be reduced. The distances D1 and D2 are the distances between the centers of members in the X-axis direction.

The performance of a magnetic shield varies with the distance from the busbar 11, the shape of the magnetic shield, and other factors. Therefore, the thicknesses T1 and T2 can be adjusted to values in the range that provide appropriate shielding functions in accordance with the distances D1 and D2 and the shapes of the first magnetic shield 94A and the second magnetic shield 94B. For example, it is desirable to set T1 to a value that is greater than or equal to about 1/2 of T2 and less than or equal to about 2/3 of T2.

The embodiments described herein are only examples in all respects, and the present invention is not limited to the embodiments. The scope of the invention is indicated by the claims, not by only the description of the above embodiments, and is intended to include all modifications that fall within the meaning and scope equivalent to the claims.

### [Example]

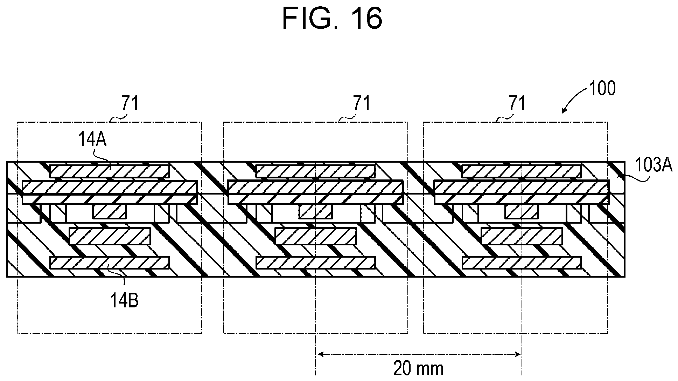

In the present example, the relationship between the mounting position of the first magnetic shield 14A and the error was measured. The measurement targets were the current sensor 7 according to the fourth embodiment illustrated in Fig. 12 and an existing current sensor 100 illustrated in Fig. 16.

Fig. 16 is a cross-sectional view of the existing current sensor 100 with three measurement phases. Unlike the current sensor 7 illustrated in Fig. 12, in the current sensor 100, the first magnetic shield 14A was integrally molded into a casing 103A. The experimental conditions for the current sensor 7 and the current sensor 100 were that the distance between adjacent measurement phases 71 was 20 mm, and a current was passed through the busbars 11 under the same conditions to measure the error caused by the influence of the adjacent busbar 11.

The error in the current sensor 7 was 0.03%, while the error in the current sensor 100 was 0.1%. This result indicates that the first magnetic shield 14A mounted on the substrate 15 can reduce the error caused by the influence of the adjacent busbar 11 more than when the first magnetic shield 14A is formed integrally with the casing 103A.

### Industrial Applicability

The present invention is useful as a current sensor with a busbar through which a large current flows as a current to be measured.

### Reference Signs List

1, 2, 3, 4, 5, 6, 6a, 6b, 7, 8, 9 current sensor
11 busbar
12 magnetic detection unit
13 casing
14A first magnetic shield
14AL side surface
14AS upper surface
14B second magnetic shield
15 substrate
15S mounting surface
151 protruding portion
151E edge
16 spacer portion
17 body
18 extending portion
181 facing portion
182 protective portion
33 casing
36 spacer portion
37 body
38 extension portion
382 protective portion
383 guard portion
383E edge
39 communicating portion
39Y communicating portion
39Z communicating portion
48 extension portion
482 protective portion
483 guard portion
483Y guard portion
483Z guard portion
583 guard portion
584 plate member
585 gap
64 covering portion
65 substrate
66 adhesive agent
67 plating
68 solder
71 measurement phase
73 casing
75 substrate
84A first magnetic shield
84B second magnetic shield
90 current sensor
93A casing
93B casing
94A first magnetic shield
94B second magnetic shield
100 current sensor
103A casing
D1 distance
D2 distance
L1 distance
L2 distance
L3 distance
T1 thickness
T2 thickness

## Claims

1. A current sensor comprising:
a busbar through which a current to be measured flows;
a magnetic detection unit configured to detect a magnetic field generated when the current to be measured flows through the busbar;
a casing configured to hold the busbar;
a first magnetic shield configured to reduce disturbance magnetic field noise applied to the magnetic detection unit;
a substrate having the magnetic detection unit on a surface of the substrate on one side in a first direction where three directions perpendicular to one another are defined as the first direction, a second direction, and a third direction, wherein the busbar, the magnetic detection unit, the substrate, and the first magnetic shield are disposed in this order from the one side in the first direction; and
a spacer portion provided between the casing and the substrate to separate the busbar from the magnetic detection unit in the first direction,
wherein the substrate has a protruding portion protruding from a position where the substrate is held by the spacer portion in at least one of protruding directions that are the second direction and the third direction.

2. The current sensor according to Claim 1, wherein the spacer portion is provided integrally with the casing.

3. The current sensor according to Claim 1, wherein the casing has a body on the one side of the spacer portion in the first direction, and
wherein the body has an extending portion that extends from a point where the spacer portion is provided in a direction including the protruding direction.

4. The current sensor according to Claim 3, wherein as viewed along the first direction, the extending portion has a facing portion that overlaps the protruding portion and a protective portion located on an outer side of an edge of the protruding portion.

5. The current sensor according to Claim 4, wherein the casing has a guard portion extending from the protective portion toward the other side in the first direction, and
wherein the guard portion is separated from the protruding portion as viewed along the first direction.

6. The current sensor according to Claim 5, wherein a distance from the protective portion to an edge of the guard portion is greater than or equal to a distance from the protective portion to a mounting surface of the substrate on which the first magnetic shield is mounted and less than or equal to a distance from the protective portion to an upper surface of the first magnetic shield in the first direction.

7. The current sensor according to Claim 5, wherein at least part of the guard portion overlaps the protruding portion as viewed along at least one of the second direction and the third direction.

8. The current sensor according to Claim 7, wherein the guard portion is a plurality of plate members, and a gap is formed between every adjacent pair of the plate members.

9. The current sensor according to Claim 1, wherein the first magnetic shield is held by the substrate, and
wherein a side surface of the first magnetic shield is covered by a covering portion.

10. The current sensor according to Claim 1, comprising:
a plurality of measurement phases each including the busbar and the magnetic detection unit,
wherein the first magnetic shield is provided independently for each of the measurement phases.

11. The current sensor according to Claim 1, wherein the spacer portion has a communicating portion that is open in the second direction and/or the third direction.

12. The current sensor according to any one of Claims 1 to 11, wherein the spacer portion surrounds the magnetic detection unit as viewed along the first direction.

13. The current sensor according to Claim 1, further comprising:
a second magnetic shield,
wherein the second magnetic shield, the busbar, the magnetic detection unit, the substrate, and the first magnetic shield are disposed in this order from the one side in the first direction.

14. The current sensor according to Claim 13, wherein a distance between the first magnetic shield and the busbar in the first direction is greater than a distance between the second magnetic shield and the busbar in the first direction, and a thickness of the first magnetic shield is less than a thickness of the second magnetic shield.
